# EUROPÄISCHE PATENTSCHRIFT

(11) **EP 1 216 453 B1**
(45) Veröffentlichungstag und Bekanntmachung des Hinweises auf die Patenterteilung: **15.10.2003**
(21) Anmeldenummer: 00958199.2
(22) Anmeldetag: 01.08.2000
(51) Int. Cl.: G06K 19/077

(54) **VERFAHREN ZUR HERSTELLUNG EINER CHIPKARTE UND NACH DEM VERFAHREN HERGESTELLTE CHIPKARTE**
METHOD FOR PRODUCING A CHIP CARD AND CHIP CARD PRODUCED ACCORDING TO SAID METHOD
PROCEDE POUR LA PRODUCTION D'UNE CARTE A PUCE ET CARTE A PUCE PRODUITE SELON CE PROCEDE

(30) Priorität: 19.08.1999 DE 19939347
(43) Veröffentlichungstag der Anmeldung: 26.06.2002
(73) Patentinhaber: Orga Kartensysteme GmbH, 33104 Paderborn (DE)
(72) Erfinder: FISCHER, Dirk, D-33106 PaderBorn (DE); FANNASCH, Lothar, D-33647 Bielefeld (DE)
(86) Internationale Anmeldenummer: DE0002559
(87) Internationale Veröffentlichungsnummer: WO01015074

(56) Entgegenhaltungen:
- EP-A- 0 869 453
- DE-A- 19 735 170

## Beschreibung

Die Erfindung betrifft ein Verfahren zur Herstellung einer Chipkarte, die einen mehrschichtigen Kunststoffkartenkörper, einen in einem Chipmodul angeordneten integrierten Schaltkreis und mindestens zwei weitere elektronische Bauelemente, welche untereinander und/oder mit dem Chipmodul durch auf einer Trägerschicht angeordnete Leiterbahnen und an den Leiterbahnen angeschlossene metallische Kontaktflächen verbunden sind, aufweist sowie eine nach dem gattungsgemäßen Verfahren hergestellte Chipkarte.

Chipkarten werden in Form von Telefonkarten, Zugangsberechtigungskarten, Bankkarten usw. in zunehmendem Umfang,eingesetzt. Bei diesen Karten erfolgt die Energieversorgung und der Datenaustausch der Karte mit externen Geräten über einen Berührungskontakt auf direktem Wege oder durch eine in die Karte eingebettete Spule auf induktivem Wege. Bei derartigen Karten ist im Rahmen des Herstellungsprozesses nur eine Verbindung zwischen dem Chipmodul und der in den Kartenkörper eingebetteten Spule herzustellen.

Neben diesen relativ einfach aufgebauten Karten führen die gesteigerten Einsatzmöglichkeiten von Chipkarten dazu, auch solche Chipkarten zu konzipieren, die weitere elektronische Bauelemente wie beispielsweise eine Tastatur und ein Display aufweisen und als sogenannte interaktive Chipkarten bezeichnet werden. Die zusätzlichen Bauelemente können unterschiedliche Bauhöhen besitzen, aufgrund dessen muß die Verbindung zwischen Tastatur, Display und integriertem Schaltkreis innerhalb der Chipkarte auf relativ komplizierte Weise herbeigeführt werden.

Aus der EP 0 869 453 A2 ist es bekannt, für die Herstellung einer kontaktlosen Chipkarte eine Spulenträgerschicht mit darauf angeordneter Spule und Spulenanschlüssen sowie einen Spuleanschluss seifig aufzubringende Abdeckschicht und eine oder . mehrere dicken Ausgleichschichten aufzubringen. Nachteilig an dem bekannten Verfahren ist, daß eine Kontaktierung elektronischer Bauelemente nur auf der Ebene der Trägerschicht oder einer einzigen zur Trägerschicht parallelen Ebene möglich ist.

Aus der DE 197 35 170 A1 ist Chipmodul bekannt, bei dem zwei Chips nebeneinander und innerhalb einer Vertiefung einer Trägerschicht angeordnet sind. Dabei sind der erste und der zweite Chip in unterschiedlichen Höhenlagen zueinander angeordnet.

Aufgabe der vorliegenden Erfindung ist es daher, daß gattungsgemäße Verfahren zur Herstellung einer Chipkarte sowie eine nach dem Verfahren hergestellte Chipkarte so weiter zu entwickeln, daß die formschlüssige Einsetzung von mehreren verschieden dicken Bauteilen gewährleistet ist.Diese Aufgabe wird im Zusammenhang mit den gattungsbildenden Merkmalen durch die technische Lehre der Ansprüche 1 und 16 gelöst. Dabei ist das Verfahren durch die nachfolgend beschriebenen Verfahrensschritte gekennzeichnet. lm Rahmen der Unteransprüche werden weitere vorteilhafte und zweckmäßige Ausgestaltungen des Verfahrens aufgezeigt. Die Erläuterung der einzelnen Verfahrensschritte erfolgt nachfolgend unter Bezugnahme auf die beigefügten Zeichnungen.

Es zeigt:
- Figur 1: eine Draufsicht auf eine erfindüngsgemäße Chipkarte, wobei die Oberfläche an zwei Stellen zur Sichtbarmachung der Trägerschicht für die Leiterbahnen durchbrochen ist,
- Figur 2: eine Schnittdarstellung der einzelnen Kartenschichten vor dem Laminieren in Explosionsdarstellung,
- Figur 3: einen Schnitt durch eine fertig laminierte Karte,
- Figur 4: einen Schnitt durch eine fertig laminierte Karte mit eingesetztem Chipmodul und
- Figur 5 - 7: Schnittdarstellungen durch eine erfindungsgemäße Karte, bei denen das einzusetzende Chipmodul mit den Kontaktflächen der Leiterbahnträgerschicht und der Karte auf unterschiedliche Weise verbunden ist.

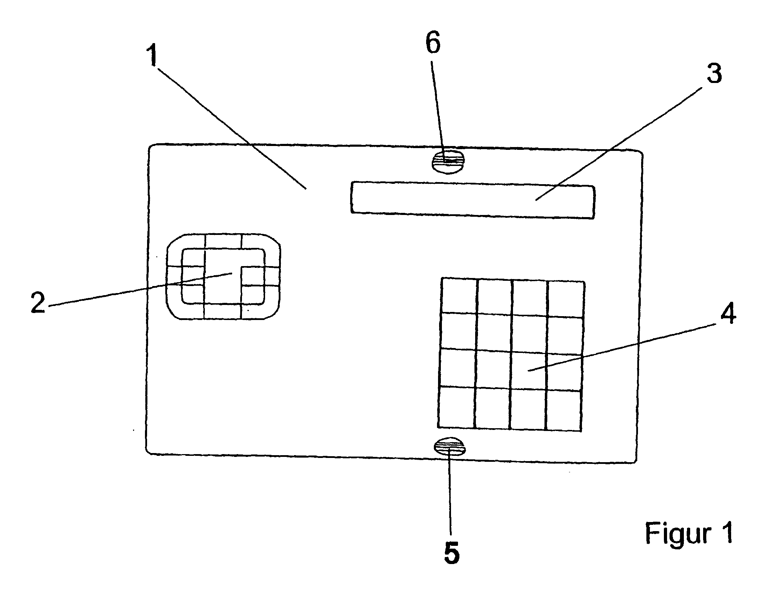

Die durch das erfindungsgemäße Verfahren nach einer bevorzugten Ausführungsform hergestellte Chipkarte besteht aus einem mehrschichtigen Kunststoffkartenkörper 1, in dem ein Chipmodul 2 und als weitere elektronische Bauelemente ein Display 3 sowie eine Tastatur 4 eingesetzt sind. Mit Hilfe der Tastatur 4 lassen sich kontrolliert über das Display 3 Informationen eingeben, welche im Chipmodul 2 verarbeitet und entweder direkt über Kontaktflächen am Chipmodul oder indirekt über eine innerhalb des Kunststoffkartenkörpers 1 eingebettete -Spule an externe Geräte weitergegeben werden können. In der Figur 1 ist die Oberfläche der Chipkarte an zwei Stellen durchbrochen, um innerhalb der Chipkarte auf einer Trägerschicht angeordnete Leiterbahnen 5,6, die in der Abbildung in Form der Spule zur Datenübertragung ausgebildet sind, zu verdeutlichen. Das Chipmodul 2,. das Display 3 und die Tastatur 4 sind mit den Leiterbahnen durch metallische Kontaktflächen 7 verbunden, die eine sehr viel größere Ausdehnung aufweisen als die übrigen Leiterbahnen innerhalb der Chipkarte. Leiterbahnen und metallische Kontaktflächen 7 werden auf einer gemeinsamen Leiterbahnträgerschicht 8 angeordnet. Die. Herstellung der Leiterbahnschicht erfolgt üblicherweise durch Herausätzen der Kontaktflächen 7 und der Leiterbahnen aus einer elektrisch leitend (vorzugsweise mit Kupfer) beschichteten Kunststoff-Folie.

Ein bevorzugtes Ausführungsbeispiel des erfindungsgemäßen Verfahrens sieht nunmehr vor, zur Herstellung der in Figur 1 dargestellten interaktiven Chipkarte sieben einzelne Schichten zu einem Kunststoffkartenkörper 1 zu laminieren. Zu diesem Zweck werden zunächst zwei Abdeckschichten 10 und 11 über der Leiterbahnträgerschicht 8 an ihrer den elektronischen Bauelementen und dem Chipmodul zugewandten Oberseite plaziert, an der sich die Leiterbahnen 9 sowie die metallischen Kontaktflächen 7 befinden. Über den Abdeckschichten wird eine Dickenausgleichsschicht 12 plaziert und darüber eine kartenvorderseitige Deckschicht als Overlay. Auf der den Leiterbahnen und metallischen Kontaktflächen abgewandten Unterseite der Leiterbahnträgerschicht 8 werden ebenfalls eine Dickenausgleichsschicht 12 sowie eine Deckschicht 14 angeordnet. Die Dickenausgleichsschicht 12 besteht aus eine bedruckten Kunststoff-Folie, während für die darüber aufzubringende Deckschicht 14 transparente Overlay-Folien eingesetzt werden.

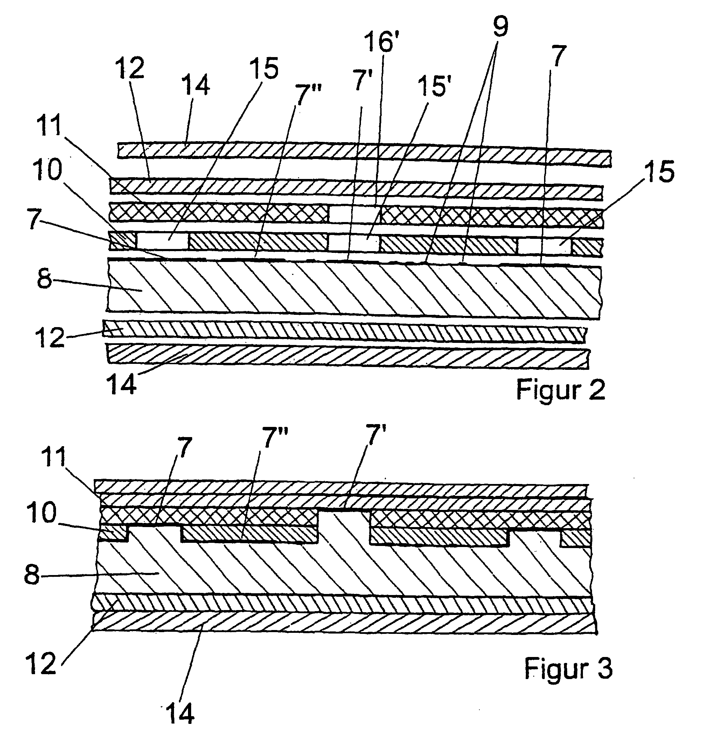

Wie aus der Figur 2 deutlich hervorgeht, besitzt die Abdeckschicht 10 mehrere Aussparungen 15,15', die in ihrer Anordnung innerhalb der Abdeckschicht.1 0 mit der Anordnung der metallischen Kontaktflächen 7 auf der Leiterbahnträgerschicht 8 korrespondieren. Während des Herstellungsverfahrens wird die Abdeckschicht 10 so ausgerichtet, daß die entsprechenden Aussparungen 15 und 15' genau über den metallischen Kontaktflächen 7 liegen.

Aus der Figur 2 wird darüber hinaus deutlich, daß die über der Abdeckschicht 10 plazierte Abdeckschicht 11 ebenfalls Aussparungen 16' aufweist, die analog zu denjenigen Aussparungen 15, 15' der Abdeckschicht 10 in ihre Anordnung ebenfalls an den metallischen Kontaktflächen 7 der Leiterbahnträgerschicht 8 orientiert sind. Allerdings besitzt die Abdeckschicht 11 im Gegensatz zur Abdeckschicht 10 über bestimmten metallischen Kontaktflächen 7 keine Aussparung. Im Rahmen des Herstellungsverfahrens wird die zweite Abdeckschicht 11 über der Leiterbahnträgerschicht 8 so plaziert, daß die korrespondierenden Aussparungen 16' und 15' übereinander und über einer metallischen Kontaktfläche 7' angeordnet sind.

Im darauffolgenden Herstellungsverfahrerisschritt werden die übereinander angeordneten sieben Schichten des Kunststoffkartenkörpers 1 in eine Laminationspresse eingelegt, in der sie unter Druck- und Wärmeeinfluß miteinandet verbunden werden. Bei diesem Laminierungsprozeß werden die metallischen Kontaktflächen 7, 7' innerhalb der über diesen angeordneten Aussparungen 15 bzw. 15' und 16' soweit hochgedrückt, bis sie an einer Abdeckschicht 11 oder einer Dickenausgleichsschicht 12 zur Anlage kommen. Die metallischen Kontaktflächen 7, 7' befinden sich somit gegenüber der Leiterbahnträgerschicht 8 auf unterschiedlichen Erhöhungen innerhalb des Kunststoffkartenkörpers 1, wie dies aus der Figur 3 deutlich hervorgeht. Die Verbindung zwischen den direkt auf der Leiterbahnträgerschicht 8 verbleibenden Leiterbahnen 9 und den hochgedrückten metallischen Kontaktflächen 7 ist durch das dehnbare Material Kupfer der Leiterbahnen hierbei nach wie vor gewährleistet. Nach Beendigung des Laminationsprozesses besitzt die erfindungsgemäße Chipkarte somit metallische Kontaktflächen 7, 7' und 7" auf drei verschiedenen Niveaus innerhalb des Kunststoffkartenkörpers 1.

Der sich an den Laminationsvorgang anschließende weitere Verfahrensschritt der Herstellung sieht das Einfräsen von Aussparungen unterschiedlicher Tiefe in den laminierten Kunststoffkartenkörper 1 vor, wobei die innerhalb des Kartenkörpers 1 in verschiedener Tiefe befindlichen metallischen Kontaktflächen 7, 7' und 7" freigelegt werden. Die angehobenen metallischen Kontaktflächen 7, 7' und 7" stellen beim Fräsvorgang sicher, daß die direkt auf der Leiterbahnträgerschicht 8 befindlichen, Leiterbahnen 9 beim Fräsvorgang nicht beschädigt werden.

Nach Beendigung des Fräsvorganges befinden sich somit innerhalb des Kunststoffkartenkörpers 1 mehrere Aussparungen 17 unterschiedlicher Tiefe, in die beispielsweise neben dem Chipmodul 2 weitere elektronische Bauelemente wie beispielsweise das Display 3 oder die Tastatur 4 eingesetzt werden können, die bei unterschiedlicher Bauhöhe trotzdem aufgrund des erfindungsgemäßen Herstellungsverfahrens nicht über die Oberfläche des Chipkartenkörpers vorstehen. Um das Anheben der metallischen Kontaktflächen 7, und 7' zu begünstigen, wird für die Leiterbahnträgerschicht 8 ein Kunststoffmaterial mit einer niedrigeren Formbeständigkeit unter dem Einfluß von Druck und Wärme verwendet als für die Abdeckschichten 10, 11 und die darüber angeordnete Dickenausgleichsschicht 12. Die niedrigere Formbeständigkeit der Leiterbahnträgerschicht 8 drückt sich in einer niedrigen Vicat-Erweichungstemperatur aus. Dies kann zum Beispiel dadurch bewirkt werden, daß dem Kunststoffmaterial Füllstoffartikel die die Formbeständigkeit erhöhen, beigemengt werden, wobei die Füllstoffkonzentration der Leiterbahnträgerschicht 8 geringer als die der übrigen Schichten, 10, 11, 12 ist, wodurch eine geringere Formbeständigkeit der Leiterbahnträgerschicht 8 erreicht wird. In einer bevorzugten Ausgestaltung bestehen die Kartenschichten aus thermisch nicht rekristallisierendem Polyester (Polyethylenterephthalt; PETG). Dieses Material ist umweltfreundlich zu recyceln oder zu entsorgen.

Statt der gleichen Verwendung eines Kartenmaterials für alle Kartenschichten, jedoch mit unterschiedlicher Füllstoffpartikelanzahl in der Leiterbahnträgerschicht 8 kann es auch vorgesehen werden, für die Leiterbahnträgerschicht 8 einen gänzlich anderen Kunststoff als für die Abdeckschichten 10, 11 und die Dickenausgleichsschicht 12 zu verwenden - z. B. PVC für die Leiterbahnträgerschicht und Polykarbonat für die Abdeckschichten 10 und 11 sowie die Dickenausgleichsschicht 12. Die Vicat-Erweichungstemperaturen von PVC liegen je nach Art des Kunststoffs ca. zwischen 70 bis 80° C, während die Vicat- Erweichungstemperaturen von PC je nach Art zwischen ca. 120 und 130° C liegen. Die Dicke der metallischen Kontaktflächen 7 sowie der Leiterbahnen 9 beträgt zwischen 20 und 80 µm, wohingegen die Dicke der Abdeckschichten 10, 11 im Bereich zwischen 40 und 200 µm liegt. Auf jeden Fall ist die Dicke der metallischen Kontaktflächen 7 kleiner als die Dicke der Abdeckschichten 10 und 11.

Für die Formgestaltung der in den Abdeckschichten 10 und 11 eingebrachten Aus¬ sparungen 15, 15' und 16' hat sich eine kreisrunde Variante als besonders vorteilhaft herausgestellt, darüber hinaus sind natürlich auch viereckige oder anders ausgebildete Grundrißformen der Aussparungen 15, 15' und 16' denkbar. Die metallischen Kontaktflächen 7 sind als rechteckförmige Gebilde gestaltet, wobei die Anordnung der Aussparungen 15, 15' , 16' und der Kontaktflächen 7 sowohl mittig zueinander als auch außermittig ausgeführt sein kann, je nachdem wie dies der Anschluß der einzusetzenden elektronischen Bauteile und des Chipmoduls 3 erfordert.

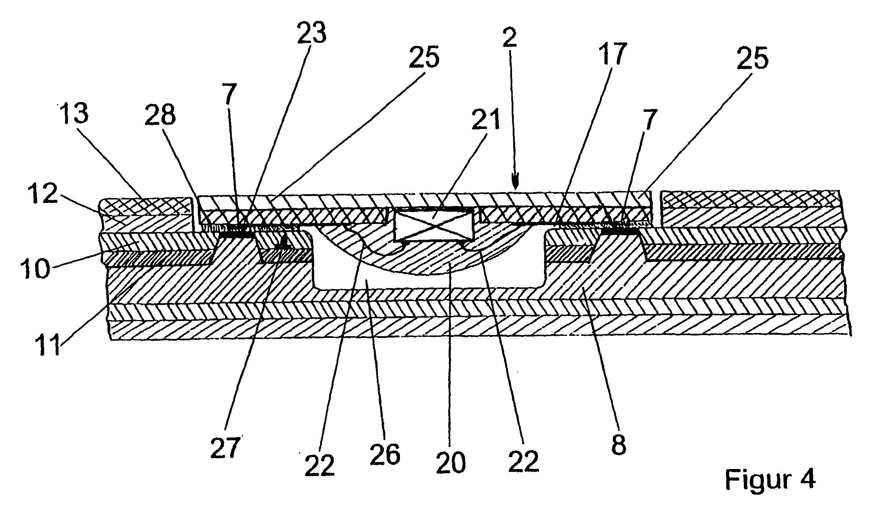

In der Figur 4 ist in Schnittdarstellung beispielhaft eine Aussparung 17 innerhalb des Kunststoffkartenkörpers 1 dargestellt, in die ein Chipmodul 2 eingesetzt ist. Das für die Chipkarte verwendete Chipmodul 2 besteht aus einem ersten Teil in Form eines Gußgehäuses 20, welches die integrierte Schaltung 21 und die Anschiußleitungen. 22 von der integrierten Schaltung 21 zu den Anschlußflächen 23 zur Verbindung mit den metallischen Kontaktflächen 7 aufweist. Darüber hinaus weist das Chipmodul 2 einen zweiten Teil 25 auf, der über den Rand des Gußgehäuses 20 hinausragt und die metallischen Anschlußflächen 23 zur Verbindung mit den Kontaktflächen 7 aufweist.

Entsprechend der in der Figur 4 dargestellten Form des Chipmoduls 2 wird die Aussparung 17 zur Aufnahme des Chipmoduls 2 innerhalb des Kunststoffkartenkörpers 1 zweistufig mit einer mittig in der Aussparung 17 liegenden Vertiefung 26 ausgestaltet, wobei die nach dem Fräsvorgang freigelegten metallischen Kontaktflächen 7 auf den Auftageschultem 27 der Aussparung 17 liegen. Das Chipmodul 2 wird dann . zumindest mit seinem über das Gußgehäuse 20 hinausragenden zweiten Teil 25 auf der ausgefrästen Auflageschulter 27 liegend mit dem Kartenkörper 1 verbunden, wobei eine elektrisch leitende Verbindung zwischen den Anschtußflächen 23 des Chipmoduls 2 und den korrespondierenden metallischen Kontaktflächen 7 hergestellt wird. Bei Verwendung von sehr flachen Chipmodulen kann auf eine zweistufige Aussparung mit zusätzlicher mittiger Vertiefung jedoch auch verzichtet werden. Die Verbindung der Anschlußflächen 23 des Chipmoduls 2 können über einen elektrisch leitfähigen Kleber 28, einen Lötprozeß oder durch Verschweißung mit den metallischen Kontaktflächen 8 elektrisch leitend verbunden werden. Dabei kann die elektrisch leitende Verbindung (z. B. bei der Verwendung spezieller Leitkleber,) auch für die mechanische Fixierung des Chipmoduls 2 im Kunststoffkartenkörper 1. ausreichen. Vorzugsweise wird das Chipmodul 2 jedoch durch zusätzliche Klebeverbindungen im Kartenkörper gehalten.

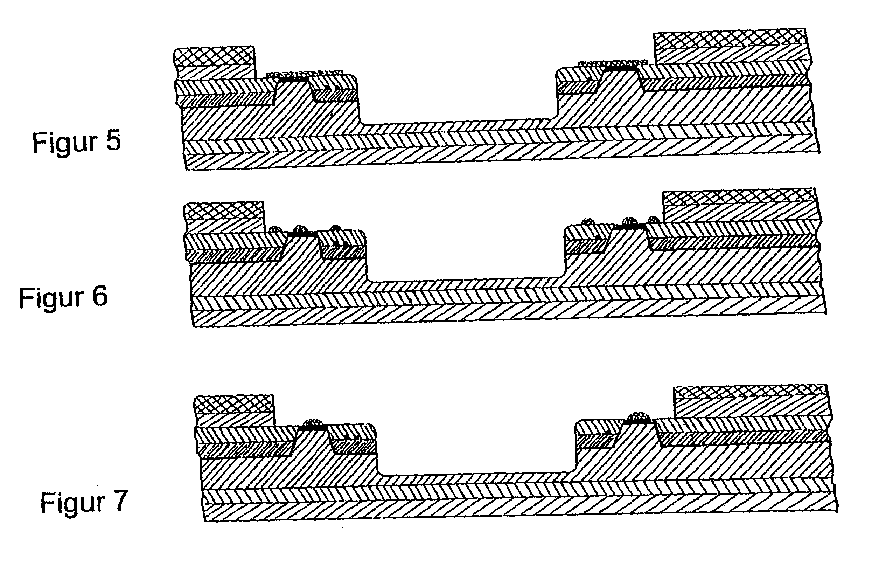

In den Figuren 5 bis 7 sind unterschiedliche Arten des Kleberauftrages dargestellt. Die Figur 5 beispielsweise zeigt eine Möglichkeit, den Leitkleber mit einem Dispenser vollflächig über einen Bereich, größer als die freigelegten metallischen Kontaktflächen 7, aufzubringen. Dies hat den Vorteil, daß der Steueraufwand für den Kleberauftrag in vorteilhafter Weise gering bleibt. Dem gegenüber werden in den Figuren 6 und 7 jeweils nur ein Tropfen des leitfähigen Klebers auf die metallischen Kontaktflächen 7 aufgebracht, wobei in der Figur 6 zusätzlich auf der Auflageschulter 27 der Aussparung 17 Tropfen eines nicht leitenden Klebers zur sicheren. Fixierung des Chipmoduls 2 im Kartenkörper 1 aufgebracht sind. Natürlich kann auch die Verwendung eines Heißklebers für die Fixierung der elektronischen Bauteile innerhalb des Kunststoffkartenkörpers 1 vorgesehen sein.

## Patentansprüche

1. Verfahren zur Herstellung einer Chipkarte, die einen mehrschichtigen Kunststoffkartenkörper (1), einen in einem Chipmodul (2) angeordneten integrierten Schaltkreis und mindestens zwei weitere elektronische Bauelemente (3, 4), welche untereinander und mit dem Chipmodul (2) durch auf einer Trägerschicht (8) angeordnete Leiterbahnen (5, 6, 9) und an den Leiterbahnen angeschlossene metallische kontaktflächen (7) verbunden sind, wobei bei unterschiedlicher Bauhöhe der elektronischen Bauelemente (3, 4) dieselben, nicht über die Oberfläche des Chipkartenkörpers vorstehen, aufweist,
**gekennzeichnet durch folgende Verfahrensschritte:**
- Anordnung von mindestens zwei Abdeckschichten (10, 11) über der Leiterbahnträgerschicht (8) an ihrer den elektronischen Bauelementen (3, 4) und dem Chipmodul (2) zugewandten Oberseite, wobei die Abdeckschichten (10, 11) jeweils mit Aussparungen (15, 15', 16') versehen sind,
- Positionierung der Abdeckschichten (10, 11) über der Leiterbahnträgerschicht (8) dergestalt, daß die in den einzelnen Abdeckschichten (10, 11) ) befindlichen Aussparungen (15, 15', 16') über den metallischen Kontaktflächen (7) und teilweise übereinander angeordnet sind,
- Plazierung mindestens einer die Abdeckschichten (10,11) überdeckenden Dickenausgleichsschicht (12),
- Laminieren der übereinandergelegten Kartenschichten in einer Laminationspresse unter Druck- und Wärmeeinfluß, wobei die metallischen Kontaktflächen (7) innerhalb der über diesen angeordneten Aussparungen (15, 15', 16') der Abdeckschichten (10, 11) so weit hochgedrückt werden, bis sie an einer Abdeckschicht (10) oder einer Dickenausgleichsschicht (12) zur Anlage kommen,
- Einfräsen von Aussparungen (17) unterschiedlicher Tiefe in den laminierten Kunststoffkartenkörper (1) nach dessen Entnahme aus der Laminationspresse, wobei die innerhalb des Kartenkörpers (1) in verschiedener Tiefe befindlichen metallischen Kontaktflächen (7, 7') freigelegt werden und
- Einsetzen des Chipmoduls (2) und der übrigen elektronischen Bauelemente (3, 4) in die gefrästen Aussparungen (17) des Kartenkörpers (1) und Herstellung von elektrisch leitenden Verbindungen zwischen den Kontaktflächen (7) und korrespondierenden Anschfußflächen (23) des Chipmoduls (2) und der. elektronischen Bauelemente (3,4).

2. Verfahren nach Anspruch 1, **dadurch gekennzeichnet, daß** das KunststoffMaterial der Leiterbahnträgerschicht (8) eine niedrigere Formbeständigkeit unter dem Einfluß von Druck und Wärme aufweist als die Kunststoff-Materialien der Abdeckschichten (10, 11) und der darüber angeordneten Dickenausgleichsschicht(en) (12).

3. Verfahren nach Anspruch 2, **dadurch gekennzeichnet, daß** die Leiterbahnträgerschicht (8),die Abdeckschichten (10,11) sowie die Dickenausgteichsschicht (12) aus dem gleichen Kunststoff bestehen, wobei der Kunststoff Füllstoffartikel aufweist, die die Formbeständigkeit erhöhen, und die Füllstoffkonzentration der Leiterbahnträgerschicht (8) und damit die Formbeständigkeit dieser Schicht geringer als die der anderen Schichten ist.

4. Verfahren nach Anspruch 3, **dadurch gekennzeichnet, daß** der Kunststoff themisch nicht rekristallisierendes Polyester (Polyethylenterephthalt; PETG) ist..

5. Verfahren nach Anspruch 2, **dadurch gekennzeichnet, daß** die Leiterbahnträgerschicht (8) aus PVC und die Abdeckschichten (10, 11) und die Dickenausgleichsschicht (12) aus Polycarbonat bestehen.

6. Verfahren nach einem der vorstehenden Ansprüche, **dadurch gekennzeichnet, daß** die Dicke der metallischen Kontaktflächen (7) auf der Leiterbahnträgerschicht (8) 20-80 µm beträgt.

7. Verfahren nach einem der vorstehenden Ansprüche, **dadurch gekennzeichnet, daß** die Dicke der Abdeckschichten (10, 11) 40-200 µm beträgt.

8. Verfahren nach einem der vorstehenden Ansprüche, **dadurch gekennzeichnet, daß** die Dickenausgleichsschicht (12), die auf den Abdeckschichten (10, 11) angeordnet ist, bedruckt ist und auf der bedruckten Dickenausgleichsschicht eine weitere transparente Dickenausgleichsschicht (14) als Kartendeckschicht angeordnet ist.

9. Verfahren nach einem der vorstehenden Ansprüche, **dadurch gekennzeichnet, daß** die in den Kartenkörper (1) eingefräste Aussparung (17) zur Aufnahme des Chipmoduls (2) zweistufig mit einer mittig in der Aussparung liegenden Vertiefung (26) und einer diese Vertiefung umgebenden Auflageschulter (27) ausgebildet wird, wobei die freigelegten Kontaktflächen (7) für das Chipmodul (2) auf der Auflageschulter (27) angeordnet sind, und ein Chipmodul (2) verwendet wird, das aus einem ersten Teil in Form eines Gußgehäuses (20), das die integrierte Schaltung (21) und die Anschlußleitungen (22) von der integrierten Schaltung zu den Anschlußflächen (23) zur Verbindung mit den metallischen Kontaktflächen (7) aufweist, und aus einem zweiten Teil (25) besteht, das über den Rand des Gußgehäuses (20) hinausragt und Anschlußflächen (23) zur Verbindung mit den Kontaktflächen (7) aufweist, wobei das Chip modul (2) zumindest mit seinem über das Gußgehäuse (20) hinausragendem zweiten Teil (25) auf der ausgefrästen Auflageschulter (27) liegend mit dem Kartenkörper (1) verbunden ist und eine elektrisch leitende Verbindung zwischen den Anschlußflächen (23) des Chipmoduls und den Kontaktflächen (7) der Leiterbahnträgerschicht (8) hergestellt wird.

10. Verfahren nach einem der vorstehenden Ansprüche, **dadurch gekennzeichnet, daß** die Anschlußflächen **(23)** des Chipmoduls (2) mit den Kontaktflächen (7) über einen elektrisch leitfähigen Kleber verbunden sind.

11. Verfahren nach einem der vorstehenden Ansprüche, **dadurch gekennzeichnet, daß** das Chipmodul (2) über den leitfähigen Kleber in dem Kartenkörper (1) mechanisch fixiert wird.

12. Verfahren nach Anspruch 10, **dadurch gekennzeichnet, daß** das Chipmodul (2) zusätzlich zu dem leitfähigen Kleber über eine Klebeverbindung in dem Kartenkörper (1) mechanisch fixiert wird.

13. Verfahren nach einem der Ansprüche 1 bis 9, **dadurch gekennzeichnet, daß** die Anschlußflächen (23) des Chipmodul (2) über einen Lötprozeß mit den Kontaktflächen elektrisch leitend verbunden werden.

14. Verfahren nach Anspruch 13, **dadurch gekennzeichnet, daß** das Chipmodul (2) über die Lötverbindung gleichzeitig in dem Kartenkörper (1) mechanisch fixiert wird.

15. Verfahren nach Anspruch 13, **dadurch gekennzeichnet, daß** das Chipmodul (2) zusätzlich zu der Lötverbindung über eine Klebeverbindung in dem Kartenkörper (1) mechanisch fixiert wird.

16. Chipkarte, die nach dem Verfahren gemäß Patentanspruch 1 hergestellt ist, wobei bei unterschiedlicher Bauhöhe der elektronischen Bauelemente (3, 4) dieselben nicht über die Oberfläche des Chipkartenkörpers vorstehen, wobei die Chipkarte mindestens aufweist:
- eine Leiterbahnträgerschicht (8) mit darauf angeordneten Leiterbahnen (5, 6, 9) und metallischen Kontaktflächen (7), wobei die Leiterbahnträgerschicht (8) im Bereich der metallischen Kontaktflächen (7) zumindest teilweise unter Ausbildung höckeriger Erhebungen erhaben ausgebildet ist,
- mindestens zwei auf der Leiterbahnträgerschicht (8) angeordnete, die Leiterbahnen (5, 6, 9) vollkommen abdeckenden Abdeckschichten (10,11), wobei die höckerartigen Erhebungen der Leiterbahnträgerschicht (8) im Bereich der metallischen Kontaktflächen (7) in Aussparungen (15, 15', 16, 16') der Abdeckschichten (10, 11) zumindest teilweise in unterschiedlicher Höhe im Querschnitt des Kartenkörpers (1) formschlüssig angeordnet sind.

## Claims

1. Process for manufacturing a smart card having a multi-layered plastic card, body (1), an integrated circuit arranged in a chip module (2), and at least two further electronic components (3, 4) which are connected by means of conductor paths (5, 6, 9) arranged on a carrier layer (8) to one another and to the chip module (2) and to metallic contact areas (7) connected to the conductor paths, in which the electronic components (3, 4) do not protrude beyond the surface of the smart card body if said electronic components are of different heights, **characterized by the following process steps:**
- arrangement of at least two covering layers (10, 11) over the conductor carrier layer (8) on its upper side facing the electronic components (3, 4) and the chip module (2), in which the covering layers (10, 11) are provided with cavities (15, 15', 16') in each case,
- positioning of the covering layers (10, 11) over the conductor carrier layer (8) in such a way that the cavities (15, 15', 16') in the individual covering layers (10, 11) are arranged above the metallic contact areas (7) and in some cases above one another,
- placement of at least one thickness compensation layer (12) covering the covering layers (10, 11),
- lamination of the stacked card layers in a lamination press under the influence of pressure and heat, whereby the metallic contact areas (7) within the cavities (15, 15', 16') of the covering layers (10, 11) which are arranged above said areas are pushed up until they come to rest against a covering layer (10) or a thickness compensation layer (12), larninated plastic card
- milling of cavities (17) of different depths into the laminated plastic card body (1) following removal from the lamination press, whereby the metallic contact areas (7, 7') located at different depths within the card body (1) are exposed, and
- insertion of the chip module (2) and the other electronic components (3, 4) into the milled cavities (17) of the card body (1) and production of electrically conductive connections between the contact areas (7) and corresponding connection areas (23) of the chip module (2) and of the electronic components (3, 4).

2. Process according to Claim 1, **characterized in that** the plastic material of the conductor carrier layer (8) has a lower dimensional stability under the influence of pressure and heat than the plastic materials of the covering layers (10, 11) and the thickness compensation layer(s) (12) arranged above them.

3. Process according to Claim 2, **characterized in that** the conductor carrier layer (8), the covering layers (10, 11) and the thickness compensation layer (12) are made of the same plastic, in which the plastic contains filler material which increases the dimensional stability, and the filler concentration of the conductor carrier layer (8) and consequently the dimensional stability of said layer is lower than that of the other layers.

4. Process according to Claim 3, **characterized in that** the plastic is thermally non-recrystallizing polyester (polyethylene terephthalate; PETG).

5. Process according to Claim 2, **characterized in that** the conductor carrier layer (8) is made of PVC and the covering layers (10, 11) and the thickness compensation layer (12) are made of polycarbonate.

6. Process according to one of the preceding claims, **characterized in that** the thickness of the metallic contact areas (7) on the conductor carrier layer (8) is 20-80 µm.

7. Process according to one of the preceding claims, **characterized in that** the thickness of the covering layers (10, 11) is 40-200 µm.

8. Process according to one of the preceding claims, **characterized in that** the thickness compensation layer (12), which is arranged on the covering layers (10, 11), is printed and a further transparent thickness compensation layer (14) is arranged on the printed thickness compensation layer as a card cover layer.

9. Process according to one of the preceding claims, **characterized in that** the cavity (17) milled into the card body (1) for receiving the chip module (2) is of a two-step design having an indentation (26) located in the middle of the cavity and a supporting shoulder (27) surrounding said indentation, in which the exposed contact areas (7) for the chip module (2) are arranged on the supporting shoulder (27), and a chip module (2) is used which is composed of a first part in the form of a molded housing (20) having the integrated circuit (21 ) and the connecting wires (22) from the integrated circuit to the connection areas (23) for connection to the metallic contact areas (7), and of a second part (25) which projects over the edge of the molded housing (20) and has connection areas (23) for connection to the contact areas (7), in which the chip module (2) is horizontally connected, at least by its second part (25) projecting beyond the molded housing (20), to the card body (1) on the milled-out supporting shoulder (27), and an electrically conductive connection is produced between the connection areas (23) of the chip module and the contact areas (7) of the conductor carrier layer (8).

10. Process according to one of the preceding claims, **characterized in that** the connection areas (23) of the chip module (2) are connected to the contact areas (7) by means of an electrically conductive adhesive.

11. Process according to one of the preceding claims, **characterized in that** the chip module (2) is mechanically fixed in the card body (1) by means of the electrically conductive adhesive.

12. Process according to Claim 10, **characterized in that**, in addition to the electrically conductive adhesive, the chip module (2) is mechanically fixed in the card body (1) by means of an adhesive connection.

13. Process according to one of Claims 1 to 9, **characterized in that** the connection areas (23) of the chip module (2) are electroconductively connected to the contact areas using a soldering process.

14. Process according to Claim 13, **characterized in that** the chip module (2) is simultaneously fixed mechanically in the card body (1) by means of the soldered connection.

15. Process according to Claim 13, **characterized in that**, in addition to the soldered connection, the chip module (2) is mechanically fixed in the card body (1) by means of an adhesive connection.

16. Smart card manufactured using the process according to Patent Claim 1, in which the electronic components (3, 4) do not protrude beyond the surface of the smart card body if said electronic components are of different heights, wherein the smart card has at least:
- one conductor carrier layer (8) having conductor paths (5, 6, 9) and metallic contact areas (7) arranged thereon, in which in the area of the metallic contact areas (7) the conductor carrier layer (8) is raised at least partially so as to form protruberant bumps,
- at least two covering layers (10, 11) arranged on the conductor carrier layer (8) and fully covering the conductor paths (5, 6, 9), in which in the area of the metallic contact areas (7) the protruberant bumps of the conductor carrier layer (8) are arranged with a positive fit in cavities (15, 15', 16, 16') of the covering layers (10, 11) at least partially at different heights in the cross-section of the card body (1).

## Revendications

1. Procédé pour la fabrication d' une carte à puce qui présente un corps de carte en matière plastique à plusieurs couches (1), un circuit de commutation intégré, disposé dans un module à puce (2) et, au moins, deux autres composants électroniques (3, 4) qui sont reliés, ensemble et avec le module à puce (2), par des pistes conductrices (5, 6, 9), disposées sur une couche de support (8), et des surfaces de contact métalliques (7) qui sont raccordées aux pistes conductrices, les composants électroniques (3, 4), en cas de différences d'encombrement en hauteur de ceux-ci, ne faisant pas saillie au-dessus de la surface du corps de la carte,
**caractérisé par les étapes de procédé suivantes :**
- disposition d'au moins deux couches de recouvrement (10, 11) sur la couche de support de pistes conductrices (8), sur la surface supérieure, orientée vers les composants électroniques (3, 4) et le module à puce (2), les couches de recouvrement (10, 11) étant pourvues chacune d'évidements (15, 15', 16'),
- positionnement des couches de recouvrement (10, 11) sur la couche de support des pistes conductrices (8) de sorte que les évidements (15, 15, 16'), pratiqués dans les différentes couches de recouvrement (10, 11), soient disposés au-dessus des surfaces de contact métalliques (7) et, en partie, les uns au-dessus des autres,
- mise en place d'au moins une couche de compensation d'épaisseur (12) recouvrant les couches de recouvrement (10, 11),
- stratification des couches superposées du corps de carte, dans une presse à laminer, sous l'effet de la pression et de la chaleur, les surfaces de contact métalliques (7) étant pressées à l'intérieur des évidements (15, 15', 16') des couches de recouvrement (10, 11), disposées au-dessus d'elles, jusqu'à ce qu'elles viennent porter contre l'une des couches de recouvrement (10) ou une couche de compensation d'épaisseur (12).
- Fraisage d'évidements (17) de profondeur différente, dans le corps de la carte en matière plastique stratifiée (1), après que celui-ci ait été retiré de la presse à laminer, les surfaces de contact métalliques (7, 7'), logées dans le corps de la carte (1) à des profondeurs différentes, étant dénudées et .
- Insertion du module à puce (2) et des autres composants électroniques (3, 4) dans les évidements fraisés (17) du corps de carte (1) et réalisation des liaisons conductrices, électriques entre les surfaces de contact (7) et les surfaces de raccordement (23) correspondantes du module à puce (2) et des composants électroniques (3, 4).

2. Procédé selon la revendication 1, **caractérisé en ce que** la matière plastique de la surface de support (8) des pistes conductrices présente une plus faible résistance à la déformation sous l'effet de la pression et de la chaleur que les matières plastiques formant les couches de recouvrement (10, 11) et la (les) couche(s) de compensation d'épaisseur (12), disposée(s) sur celles-ci.

3. Procédé selon la revendication 2, **caractérisé en ce que** la couche de support (8) de pistes conductrices, les couches de recouvrement (10, 11) ainsi que la couche de compensation d'épaisseur (12) sont en même matière plastique, ladite matière plastique présentant des matières de charge, qui augmentent la résistance à la déformation, et la concentration desdites matières de charge de la couche de support (8) des pistes conductrices et, de ce fait, la résistance à la déformation de cette couche, étant plus faibles que celles des autres couches.

4. Procédé selon la revendication 3, **caractérisé en ce que** la matière plastique est un polyester (polytéréphthalate d'éthylène; PETP) qui ne peut pas être recristallisé thermiquement.

5. Procédé selon la revendication 2, **caractérisé en ce que** la couche de support (8) des pistes conductrices est en PVC et que les couches de recouvrement (10, 11) et la couche de compensation d'épaisseur (12) sont en polycarbonate.

6. Procédé selon l'une des revendications précédentes, **caractérisé en ce que** l'épaisseur des surfaces de contact métalliques (7), sur la surface de support (8) de pistes conductrices, est de 10 à 80 µ.

7. Procédé selon l'une des revendications précédentes, **caractérisé en ce que** l'épaisseur des couches de recouvrement (10, 11) est de 40 à 200 µ.

8. Procédé selon l'une des revendications précédentes, **caractérisé en ce que** la couche de compensation d'épaisseur (12), qui est disposée sur les couches de recouvrement (10, 11), est imprimée et que, sur ladite couche de compensation d'épaisseur imprimée, une autre couches de compensation d'épaisseur transparente (14) est disposée en tant que couche de couverture de la carte.

9. Procédé selon l'une des revendications précédentes, **caractérisé en ce que** l'évidement (17), fraisé dans le corps de carte (1), destiné à recevoir le module à puce (2), est conçu à deux étages, avec une cavité (26), située au centre de l'évidement, et avec un épaulement d'appui (27) entourant cette cavité, les surfaces de contact dénudées (7) pour le module à puce (2) étant disposées sur l'épaulement d'appui (27), et que le module à puce (2) utilisé est composé d'une première partie en forme d'un boîtier en fonte (20), qui présente le circuit intégré (21) et les conduites de raccordement (22) du circuit intégré aux surfaces de raccordement (23), pour établir la liaison avec les surfaces de contact métalliques (7), et d'une deuxième partie (25), qui fait saillie au-dessus du boîtier en fonte (20) et présente des surfaces de raccordement (23) pour la liaison avec les surfaces de contact (7), le module à puce (2) étant relié au corps de carte (1), au moins par sa deuxième partie (25), faisant saillie au-dessus du boîtier en fonte (29), reposant sur l'épaulement d'appui (27) fraisé, et une liaison électrique étant établie entre les surfaces de raccordement (23) du module à puce et les surfaces de contact (7) de la couche de support (8) des pistes conductrices.

10. Procédé selon l'une des revendications précédentes, **caractérisé en ce que** les surfaces de raccordement (23) du module à puce (2) sont reliées avec les surfaces de contact métalliques (7) par l'intermédiaire d'une colle conductrice.

11. Procédé selon l'une des revendications précédentes, **caractérisé en ce que** le module à puce (2) est fixé mécaniquement, dans le corps de la carte (1), par l'intermédiaire de la colle conductrice.

12. Procédé selon la revendication 10, **caractérisé en ce que** le module à puce (2), en plus de la colle conductrice, est fixé mécaniquement, dans le corps de la carte (1), par l'intermédiaire d'un joint collé.

13. Procédé selon les revendications 1 à 9, **caractérisé en ce que** les surfaces de raccordement (23) du module à puce (2) sont reliées, en conduction électrique, avec les surfaces de contact par brasage.

14. Procédé selon la revendication 13, **caractérisé en ce que** le module à puce (2) est simultanément fixé dans le corps de la carte (1) par l'intermédiaire de la brasure.

15. Procédé selon la revendication 13, **caractérisé en ce que** le module à puce (2) est, en plus de la brasure, fixé mécaniquement dans le corps de la carte (1) par un joint collé.

16. Carte à puce, fabriquée conformément au procédé selon la revendication 1, les composants électroniques (3, 4), en cas de différence de leur encombrement en hauteur, ne font pas saillie au-dessus de la surface supérieure du corps de carte, ladite carte à puce présentant, au moins :
- une surface de support (8) de pistes conductrices, sur laquelle des pistes conductrices (5, 6, 9) et des surfaces de contact métalliques (7) sont disposées, la couche de support de pistes conductrices (8) étant conçue, dans la zone des surfaces de contact métalliques (7), au moins partiellement, en relief, en formant des bosses,
- au moins, deux couches de recouvrement (10, 11), disposées sur la couche de support de pistes conductrices (8) et recouvrant complètement lesdites pistes conductrices (5, 6, 9), les élévations en forme de bosses de la couche de support de pistes conductrices (8) étant, dans la zone des surfaces de contact métalliques (7), disposées, en engagement géométrique, dans des évidements (15, 15', 16') des couches de recouvrement (10, 11), au moins partiellement à des hauteurs différentes, dans la section transversale du corps de carte (1).
